# EUROPEAN PATENT APPLICATION

(11) **EP 2 759 782 A1**
(43) Date of publication of application: **30.07.2014**
(21) Application number: 13152711.1
(22) Date of filing: 25.01.2013
(51) Int. Cl.: F24F 13/30, F04B 19/00, H01L 23/467, H02K 44/02, F28D 1/053, G06F 1/20, H05K 7/20

(54) **Cooling apparatus using electro-hydrodynamic air moving means**

(71) Applicant: ABB Research Ltd., 8050 Zürich (CH)
(72) Inventor: Agostini, Francesco, 4800 Zofingen (CH); Stevanovic, Ivica, 8953 Dietikon (CH); Cagnoni, Davide, 27058 Voghera (PV) (IT); Habert, Mathieu, 4310 Rheinfelden (CH); Agostini, Bruno, 8006 Zürich (CH); de Falco, Carlo, 20133 Milano (IT); Parolini, Nicola, 21049 Tradate (VA) (IT)
(74) Representative: Kolster Oy Ab

(57) **Abstract**

The invention relates to a cooling apparatus, comprising: a heat exchanger (3), and a generator for generating a fluid flow which passes the heat exchanger (3). In order to obtain a cooling apparatus which is simple and reliable, the generator consists of an electro-hydrodynamic pump comprising a first electrode (4) and a second electrode (5) arranged at a distance from each other, and a power source (6) for generating an electrical field between the electrodes.

## Description

### BACKGROUND OF THE INVENTION

### FIELD OF THE INVENTION

This invention relates to a cooling apparatus and in particular to a solution of generating a fluid flow to a heat exchanger.

### DESCRIPTION OF PRIOR ART

Previously there is known a cooling apparatus with a heat exchanger where the transfer of heat is enabled by generating a gas flow, such as an air flow past the heat exchanger.

In the previously known solution a fan is utilized as a generator that generates the gas flow which passes the heat exchanger.

A drawback with the above-mentioned previously known solution is the use of a fan. In order to be able to utilize the fan, a space needs to be reserved for the fan and this space needs to have a specific shape in order to ensure that the fan will work efficiently. Additionally, a fan always generates noise, which may be a problem in certain implementations, and a fan also includes mechanically moving parts which affects the expected lifetime and reliability.

### SUMMARY OF THE INVENTION

An object of the present invention is to provide a new cooling apparatus which is simple and reliable. This is achieved with a cooling apparatus according to independent claim 1.

The use of an electro-hydrodynamic pump comprising a first electrode and a second electrode arranged at a distance from each other, and of a power source generating an electrical field between the electrodes makes it possible to obtain a generator generating a fluid flow without the use of a fan. Fluid molecules near the first electrode become ionized due to the electric field and travel toward the second electrode. During travel, the momentum from the ionized fluid molecules is transferred to surrounding fluid due to collisions. The outcome is a fluid flow passing a heat exchanger.

Preferred embodiments of the invention are disclosed in the dependent claims.

### BRIEF DESCRIPTION OF DRAWINGS

In the following the present invention will be described in closer detail by way of example and with reference to the attached drawings, in which

Figure 1 illustrates a first embodiment of a cooling apparatus,

Figure 2 illustrates a second embodiment of a cooling apparatus,

Figure 3 illustrates a first embodiment of a heat exchanger,

Figure 4 illustrates a second embodiment of a heat exchanger, and

Figure 5 illustrates a third embodiment of a heat exchanger.

### DESCRIPTION OF AT LEAST ONE EMBODIMENT

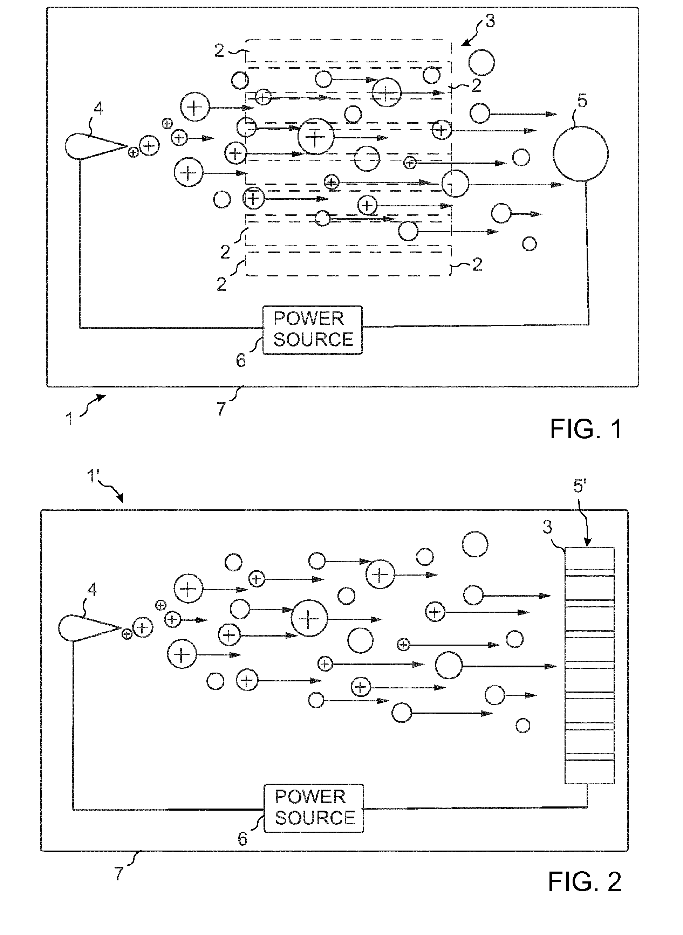

Figure 1 illustrates a first embodiment of a cooling apparatus 1. In the illustrated embodiment the cooling apparatus 1 comprises a heat exchanger 3 having a plurality of channels 2 through which fluid, such as air or another gas, may pass. The heat exchanger may be manufactured of a ceramic material or of plastics, for instance. Alternatively, as will be explained later in more detail, the heat exchanger may be manufactured of an electrically conductive material.

In order to generate a fluid flow via the channels 2 of the heat exchanger 3, a generator consisting of an electro-hydrodynamic pump is utilized. The generator comprises a first electrode 4 and a second electrode 5 arranged on opposite sides of the heat exchanger 3. The electrodes are of one or more electrically conductive materials. A power source 6 is connected to the first electrode 4 and the second electrode 5 for generating a high-voltage electric field between the first electrode 4 and the second electrode 5. The second electrode may be at earth pontential or at a lower voltage potential.

Fluid molecules near the first electrode 4 become ionized due to the high-intensity electric field and travel toward the second electrode 5. During travel, the momentum from the ionized fluid molecules is transferred to surrounding fluid due to collisions between the ionized fluid molecules and the neutral fluid molecules. The outcome is a fluid flow passing a heat exchanger 3. The fluid may be air, for instance. Due to the flow, increased heat transfer is obtained between the flowing fluid and the heat exchanger 3.

In the illustrated example it is, by way of example, assumed that the first electrode 4 is a positive high tip curvature electrode and that the second electrode 5 is a negative low tip curvature collector electrode. Generation of the fluid flow is, however, possible also when the polarity of the electrodes is opposite, in other words both with positive and negative voltages. Positive polarity, as illustrated in Figure 1 is, however, assumed to result in higher velocity and lower ozone generation (when the fluid is air).

The solution illustrated in Figure 1 has the advantage that no fan or blower with movable parts is needed. This provides flexibility in duct shape since the cross-section of the duct is not constrained. Such advantages are especially useful in applications where high-voltage low-current power is readily available, and where noise and other consequences of rotational motion cannot be accepted. The illustrated solution is therefore particularly useful as a cooling apparatus of an electrical apparatus, for instance.

In Figure 1 the cooling apparatus has, by way of example, been illustrated when mounted within a cabinet 7 (such as an electric cabinet) which tightly (such as air-tightly) encloses the interior of the cabinet 7 from the outside environment. In such an implementation the heat exchanger 3 may be connected via one or more pipes with a second heat exchanger arranged outside the cabinet 7 for passing fluid between the heat exchangers via the pipes. In such an implementation the heat exchanger 3 of Figure 1 may be an evaporator, for instance, which via the fluid flow receives heat generated by electrical components within the cabinet. The heat is transferred by the heat exchanger into fluid within the heat exchanger, and transferred via the pipes (not illustrated) to the second heat exchanger (not illustrated), which may be a condenser that dissipates the heat to the external environment, and returns the fluid to the heat exchanger 3 once it has cooled. Alternatively, a cooling apparatus as illustrated in Figure 1 may also be used in connection with a heat exchanger working as a condenser that transfers heat from within the fluid in the heat exchanger to the external environment. In that case the fluid flow enables efficient transfer of heat away from the heat exchanger.

Above it has, by way of example, been explained that the first electrode 4 is a positive electrode and that the second electrode is a negative electrode 5. In addition to this, the surface of the heat exchanger 3 may act as a third electrode connected to a ground potential. Still another alternative is that the first 4 and the second 6 electrode are at the same potential (both of them are positive or negative) and that the surface of the heat exchanger 3 is earthed. In this case two fluid flows can be generated toward the condenser. In embodiments where the heat exchanger 3 acts as an electrode, the heat exchanger, or at least the surface of it, is made of an electrically conductive material, such as aluminum or copper, for instance.

Changing of the polarity of the electrodes makes it possible to change the direction of the fluid flow, such as for cleaning the emitting/collecting electrodes by alternative cycling. For this purpose the power supply 6 may be provided with a switch for switching the polarity of the electrodes.

Figure 2 illustrates a second embodiment of a cooling apparatus. The cooling apparatus 1' of Figure 2 is very similar to the one explained in connection with Figure 1. Therefore the embodiment of Figure 2 will mainly be explained by pointing out the differences between these embodiments.

The cooling apparatus 1' of Figure 2 includes a first electrode 4 and a power source 6 similarly as in Figure 1. However, instead of having a separate second electrode, the surface of the heat exchanger 3 works as the second electrode 5'. Such an embodiment may be utilized by having the cooling apparatus enclosed by a cabinet 7, as illustrated in the figure, or alternatively in connection with a heat exchanger arranged outside the cabinet, as explained in connection with Figure 1.

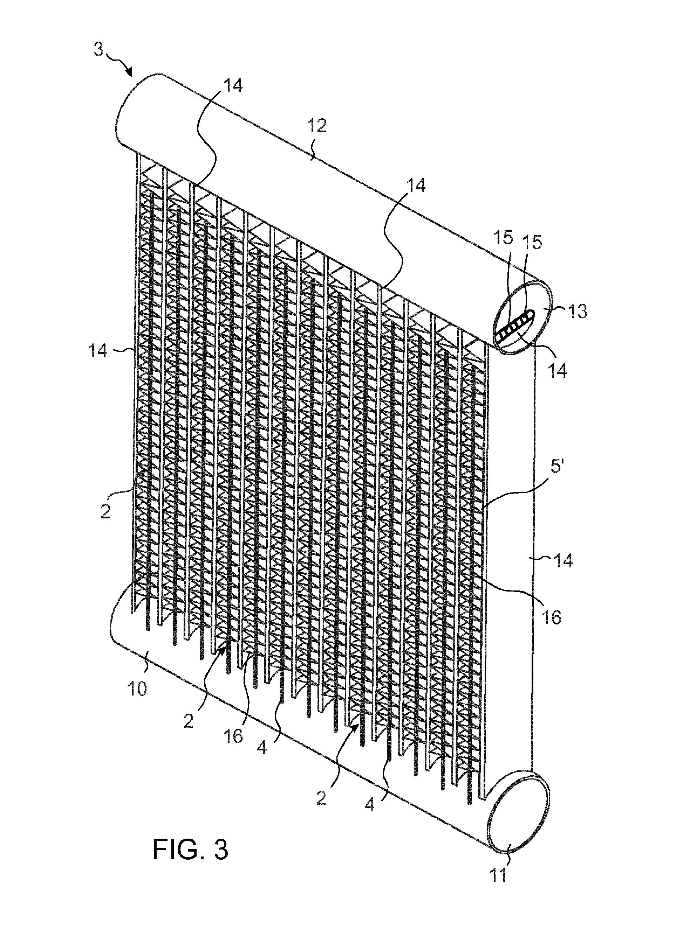

Figure 3 illustrates a first embodiment of a heat exchanger. The heat exchanger 3 illustrated in Figure 3 may be utilized as the heat exchanger 3 illustrated in Figures 1 or 2, for instance, or alternatively as a heat exchanger working as a condenser that is arranged outside the cabinet 7, for instance.

The heat exchanger 3' comprises a first connecting part 10 with an inlet 11 for receiving fluid and a second connecting part 12 with an outlet 13 for passing on fluid. A plurality of pipes 14 extend between the first connecting part and the second connecting part for passing fluid from the first connecting part 10 to the second connecting part 12. The pipes 14 are arranged at a distance from each other for providing channels 2 that allow fluid to flow past, or in the illustrated case, through the heat exchanger 3. Each pipe 14 may be provided with a plurality of flow channels 15 that extend between the first connecting part 10 and the second connecting part 12. Fins 16 may be provided between the pipes 14 in order to increase the surface area of the heat exchanger 3 that comes into contact with the fluid flow, and therefore to improve the transfer of heat between the fluid in the heat exchanger and the flowing fluid.

In the embodiment of Figure 3 the first electrode 4 is implemented as a plurality of wires arranged side by side at a distance from each other in front of the channels 2 between the pipes 14. The second electrode 5' consists of the surface of the heat exchanger 3. One alternative is to utilize fins 16 or pipes 14 of a suitable metallic material that can be utilized as the second electrode. Figure 3 does not illustrate the power source of the connections between the wires and the power source, which may be implemented as shown in Figures 1 or 2.

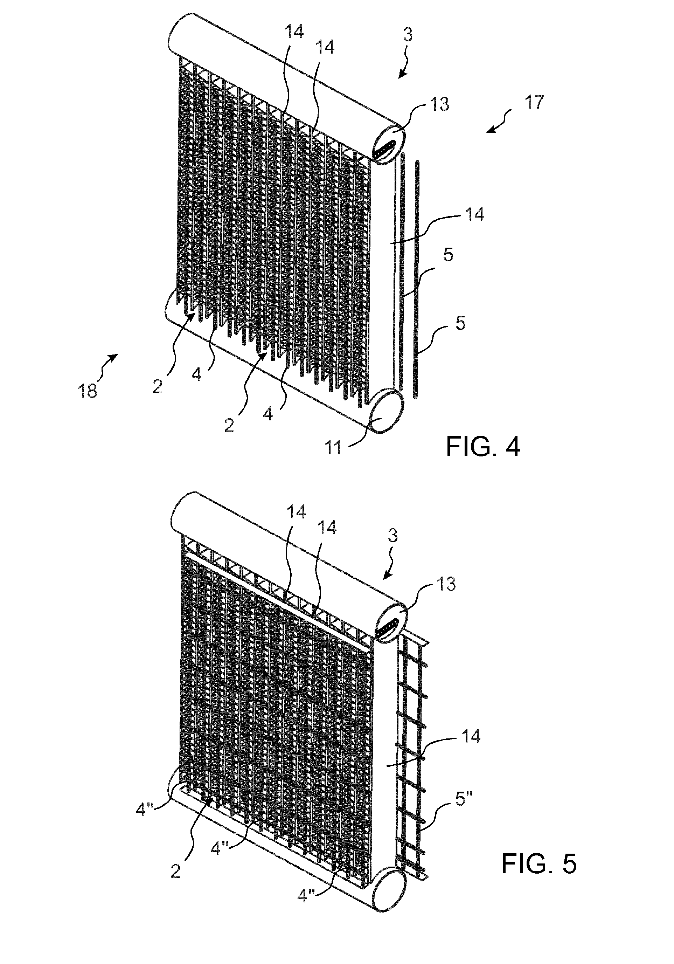

Figure 4 illustrates a second embodiment of a heat exchanger. The embodiment of Figure 4 is very similar to the one explained in connection with Figure 3. Therefore the embodiment of Figure 4 will mainly be explained by pointing out the differences between these embodiments.

The heat exchanger of Figure 4 may be utilized in the embodiment of Figure 1, for instance. In addition to the first electrode 4, which is implemented on a first side 18 of the heat exchanger as a plurality of wires arranged side by side at a distance from each other in front of the channels 2 between the pipes 14, a second electrode 5 is implemented on a second side 17 of the heat exchanger as a plurality of wires arranged side by side at a distance from each other behind the channels 2 between the pipes 14. The heat exchanger 3 is therefore arranged between the first electrode 4 and the second electrode 5.

Figure 5 illustrates a second embodiment of a heat exchanger. The embodiment of Figure 5 is very similar to the one explained in connection with Figure 4. Therefore the embodiment of Figure 5 will mainly be explained by pointing out the differences between these embodiments.

In Figure 5 the first electrode 4" and the second electrode 5" are implemented as a wire mesh having a plurality of wires crossing each other both vertically and horizontally (though wires may be arranged in any direction). The result is a fluid-permeable electrode through which fluid may pass via the openings between the wires.

Instead of having a wire mesh on both sides of the heat exchanger 3, in some embodiments it is sufficient to have such a wire mesh on only one side of the heat exchanger, in which case the surface of the heat exchanger may work as the second electrode. Alternatively, it is also possible to have a mesh of wires on one side of the heat exchanger and a plurality of parallel wires on the other side of the heat exchanger.

It is to be understood that the above description and the accompanying figures are only intended to illustrate the present invention. It will be obvious to a person skilled in the art that the invention can be varied and modified without departing from the scope of the invention.

## Claims

1. A cooling apparatus, comprising:
a heat exchanger (3), and
a generator for generating a fluid flow which passes the heat exchanger (3), **characterized in that**
the generator consists of an electro-hydrodynamic pump comprising a first electrode (4, 4") and a second electrode (5, 5', 5") arranged at a distance from each other, and a power source (6) for generating an electrical field between the electrodes.

2. A cooling apparatus according to claim 1, **characterized in that**
the heat exchanger (3) comprises channels (2) for allowing the fluid flow to pass via the heat exchanger,
the first electrode (4, 4") is arranged on a first side (18) of the heat exchanger, and
the second electrode (5, 5") is arranged on a second side (17) of the heat exchanger (3) such that the heat exchanger is arranged between the first (4, 4") and the second electrode (5, 5") and the generated fluid flow passes from the first electrode via the channels (2) of the heat exchanger to the second electrode.

3. A cooling apparatus according to claim 1, **characterized in that**
the heat exchanger (3) comprises channels (2) for allowing the fluid flow to pass via the heat exchanger,
the first electrode (4, 4") is arranged on a first side (18) of the heat exchanger, and
the second electrode (5') consists of the surface of the heat exchanger.

4. A cooling apparatus according to claim 3, **characterized in that** the cooling apparatus comprises a third electrode (5, 5") arranged on a second side (17) of the heat exchanger (3) such that the heat exchanger (3) is arranged between the first (4, 4") and the third electrode (5, 5") and the generated fluid flow passes from the first electrode (4, 4") via the channels (2) of the heat exchanger to the third electrode (5, 5").

5. A cooling apparatus according to one of claims 1 to 4, **characterized in that** the heat exchanger comprises
a first connecting part (10) with an inlet (11) for receiving fluid,
a second connecting part (12) with an outlet (13) for passing on fluid, and
a plurality of pipes (14) extending between the first connecting part (10) and the second connecting part (12) for passing fluid from the first connecting part to the second connecting part, the plurality of pipes (14) being arranged at a distance from each other for providing said channels (2) allowing the fluid flow to pass through the heat exchanger (3) between the pipes (14).

6. A cooling apparatus according to one of claims 1 to 5, **characterized in that** at least one of the electrodes (4, 5) consists of a plurality of wires arranged side by side at a distance from each other for allowing fluid to pass through the electrode between the wires.

7. A cooling apparatus according to one of claims 1 to 6, **characterized in that** at least one of the electrodes (4", 5") consists of a wire mesh having a plurality of wires crossing each other for allowing fluid to pass through the electrode between the wires.

8. A cooling apparatus according to one of claims 1 to 7, **characterized in that** the cooling apparatus is arranged in a cabinet (7) which tightly encloses the interior of the cabinet from the outside environment.

9. A cooling apparatus according to one of claims 1 to 8, **characterized in that** the cooling apparatus is a cooling apparatus of an electrical apparatus.

10. A cooling apparatus according to one of claims 1 to 9, **characterized in that** the fluid is a gas.
